# EUROPÄISCHE PATENTSCHRIFT

(11) **EP 1 330 670 B1**
(45) Veröffentlichungstag und Bekanntmachung des Hinweises auf die Patenterteilung: **24.11.2010**
(21) Anmeldenummer: 00982980.5
(22) Anmeldetag: 09.10.2000
(51) Int. Cl.: G02B 6/42

(54) **POSITIONSFIXIERUNG IN LEITERPLATTEN**
POSITION FIXING IN PRINTED CIRCUIT BOARDS
AGENCEMENT ET PROCEDE POUR BLOQUER DES COMPOSANTS EN POSITION DANS DES CARTES DE CIRCUITS

(43) Veröffentlichungstag der Anmeldung: 30.07.2003
(73) Patentinhaber: SIEMENS AKTIENGESELLSCHAFT, 80333 München (DE)
(72) Erfinder: GRIESE, Elmar, 57462 Olpe (DE); HIMMLER, Andreas, 33098 Paderborn (DE)
(86) Internationale Anmeldenummer: PCT/DE2000/003541
(87) Internationale Veröffentlichungsnummer: WO 2002/031562

(56) Entgegenhaltungen:
- WO-A-97/02501
- US-A- 4 341 439
- US-A- 5 853 626
- US-A- 6 007 257
- US-A- 6 007 257

## Beschreibung

### Technisches Gebiet

Die Erfindung betrifft eine Positionsfixierung in Leiterplatten, insbesondere für optische Koppler.

### Stand der Technik

Bislang werden auf Leiterplatten überwiegend elektrische Verbindungen verwendet, die in und auf isolierenden Lagen in einem technologisch gut beherrschten Prozeß erzeugt und mittels Löt- oder Steckverbindungen angeschlossen werden. Mittels Lötanschluß werden dabei insbesondere integrierte Schaltungen angeschlossen, die in ein Gehäuse eingebaut sind, das seinerseits zu Kontaktpunkten auf der Leiterplatte korrespondierende Kontaktpunkte aufweist. War in der Anfangszeit ein Raster von 1/10 Zoll, ca. 2,5 mm, üblich, so ist mit der Feinleitertechnik mittlerweile ein engeres Raster möglich, ohne jedoch die Größenordnung wesentlich zu verlassen. Für die Positionierung von Bauelementen auf der Leiterplatte sind daher Positioniergenauigkeiten in der Größenordnung von 1/10 mm ausreichend. Da zudem die Verbindung über Löten erfolgt, das Lot während der Lötphase flüssig ist und sich anpaßt, können kleinere Abweichungen leicht ausgeglichen werden, wobei die Oberflächenspannung des Lots zusätzlich zur Feinkorrektur verwendet wird. Bei Steckverbindern mit elektrischen Kontakten werden Toleranzen durch federnde Kontakte ausgeglichen. In beiden Fällen können die Kontaktflächen so groß wie nötig gestaltet werden, weil ein Kontakt auf jedem Teil der Kontaktfläche möglich ist.

Mit der Verfügbarkeit von schnellen elektro-optischen Wandlern ist es wünschenswert, auf einer Leiterplatte auch optische Verbindungen benutzen zu können, da diese eine größere Störfestigkeit bei sehr hoher Bandbreite aufweisen. Da die zu verwendenden optischen Wellenleiter jedoch Querschnittsabmessungen in der Größenordnung von 100µm aufweisen, muß der elektro-optische Wandler mit etwa 10µm Genauigkeit an das Ende des optischen Wellenleiters positioniert werden. Zu diesem Zweck wurden für faseroptische Verbindungen, insbesondere die als MT-Steckverbinder ('mechanically-transferable') bezeichneten Verbinder geschaffen, wie sie z.B. in dem Artikel von T. Stake u.a., MT multifiber connectors and new applications, auf S.994-999 der 1994 Proceedings 44th Electronic Components and Technology Conference, IEEE New York 1994, beschrieben sind. Dabei werden in den MT-Steckverbindern hochpräzise Hohlzylinder mit einem Innendurchmesser von 0,7mm verwendet, in die entsprechende Stifte eingreifen, um eine laterale Fixierung der beiden zu verbindenden Steckerteile zu erreichen. Damit können optische Kabel und an die optischen Kabel anzusetzende Stecker mit opto-elektronischen Wandlern gefertigt werden, bei denen die laterale Positionierung der optischen Fasern bzw. der opto-elektronischen Wandler während der Herstellung des Steckers durch entsprechende mechanische Präzision bewirkt wird.

Eine Lösung zur Ankopplung von in einer Leiterplatte eingebetteten optischen Fasern wird in dem Artikel "High Precision LIGA structures for optical fibre-in-board technology" von A.Picard et al., S.77-80 des Konferenzberichts EuPac '96, DVS Verlag, Düsseldorf 1996, beschrieben. Hier werden optische Verbindungen, die in einer Leiterplatte eingebettet sind, mit einem an der Oberfläche mündenden Steckverbinder ausgestattet. Zur Montage dieses Steckverbinders ist ein aufwendiger Prozeß notwendig, bei dem die freigelegten Fasern unter einem Winkel von 14° an die Oberfläche geholt, abgelängt, in den Verbinder eingelegt, an der Stirnseite poliert und eingeklebt werden müssen. Abgesehen von dem hohen Fertigungsaufwand geht diese Lösung davon aus, daß Leiterplatten mit eingelegten Drähten verwendet werden, so daß die optischen Fasern mit der gleichen Einrichtung verlegt werden können.

In US 4,341,439 ist ein optischer Verbinder beschrieben, der aus einem Zylinder besteht, in dem senkrecht zu der Kopfebene (und damit paralle zu der gekrümmten Zylinderfläche) sich sowohl Hohlzylinder bzw. Stifte als Führungselemente wie auch optische Leiter befinden. Es handelt sich um einen Steckverbinder, der nicht zur direkten Kopplung an in Leiterplatten mit elektrischen und optischen Leitern befindliche optische Leiter dient.

Aus US 4,341,439 ist eine Anordnung entsprechend dem Obergriff des Anspruchs 1 bekannt. Wünschenswert ist jedoch eine Lösung, bei der die Leiterplatten in gedruckter Schaltungstechnik hergestellt werden können. Der Anschluß an die optischen Wellenleiter sollte ähnlich problemlos wie der an elektrische Kontaktflächen erfolgen können, ohne daß jeder einzelne Wellenleiter konfektioniert werden muß. Dazu muß ein opto-elektronischer Wandler derart an in einer Leiterplatte eingebettete optischen Wellenleitern gekoppelt werden, daß die laterale Abweichung deutlich unter den Querschnittsabmessungen der Wellenleiter liegt.

Die Lösung geht von der Überlegung aus, daß es nicht notwendig ist, die optischen Wellenleiter an die Oberfläche zu führen. Diese können vielmehr vollständig in der Leiterplatte "vergraben" sein. Unmittelbar vor der Bestückung werden Schlitze eingefräst, die die optischen Wellenleiter und parallel zu diesen eingebettete Referenzelemente freilegen. In die eingefrästen Schlitze tauchen dann opto-elektronische Koppler ein, die gleichzeitig an der Oberfläche an entsprechende Lötanschlüsse angrenzen. Als Referenzelemente werden vorzugsweise Hohlzyliner verwendet, in die passende Stifte an den Kopplern eingreifen, wie in dem Ausführungsbeispiel genauer beschrieben wird.

Es handelt sich also um eine Anordnung zur Positionsfixierung bei Leiterplatten, vorzugsweise zur mechanischen Lagebestimmung von optischen Kopplern, wobei in einer Leiterplatte parallel zu deren Oberfläche Hohlzylinder enthalten sind, die durch einen von der Oberfläche aus eingefrästen Schlitz geöffnet werden und deren Innenwandung Positionierstifte der Koppler fixiert, sowie um ein Herstellungsverfahren dazu.

Weitere Merkmale und Vorteile der Erfindung ergeben sich aus der folgenden Beschreibung, welche in Verbindung mit den beigefügten Zeichnungen die Erfindung an Hand eines Ausführungsbeispiels erläutert.

### Kurzbeschreibung der Zeichnungen

Es zeigen
- Fig. 1: eine perspektivische Darstellung einer Leiterplatte mit eingebetteten optischen Leitern,
- Fig. 2: eine Sicht von oben auf die Leiterplatte nach Fig.1,
- Fig. 3: einen Querschnitt durch eine Leiterplatte mit einem eingesetzen Koppelelement,
- Fig. 4: einen Querschnitt wie in Fig.3, jedoch in einer da- zu parallelen Ebene,
- Fig. 5: eine zu Fig. 3 alternative optische Kopplung,
- Fig. 6: den unteren Teil eines Koppelelementes in perspek- tivischer Sicht, und
- Fig. 7 bis 10: einen Querschnitt durch eine Leiterplatte in verschiedenen Phasen der Herstellung der optischen Leiter.

### Beschreibung einer Ausführungsform der Erfindung

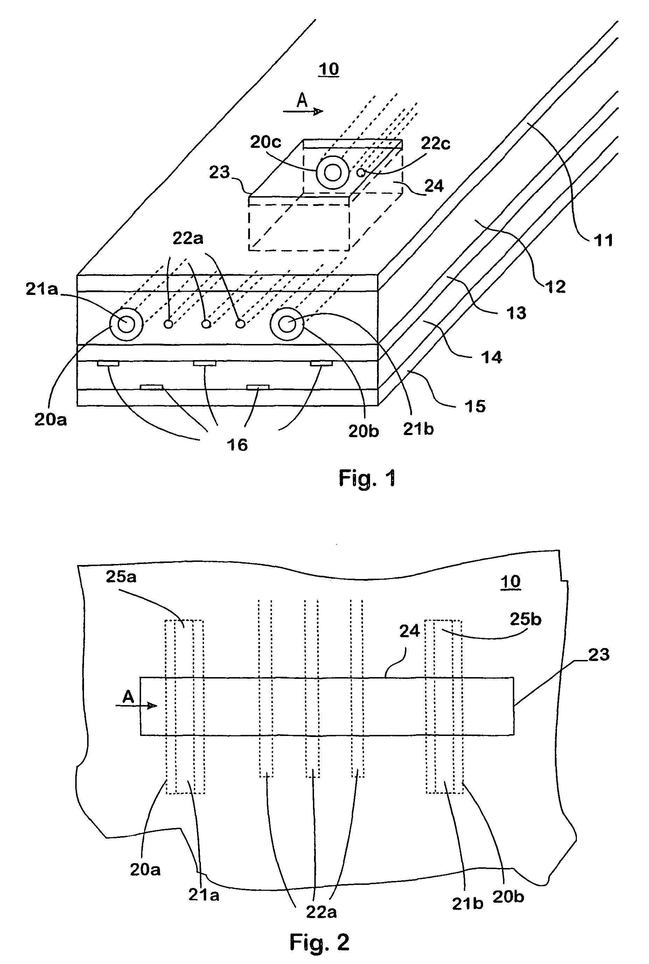

In Fig. 1 ist eine Leiterplatte 10 in perspektivischer Sicht dargestellt, wobei die Darstellung zugunsten der Übersichtlichkeit stark schematisiert, vereinfacht und nicht maßstabsgerecht ist.

Dargestellt ist eine Leiterplatte 10, die aus mehreren Schichten besteht: einer oberen Deckschicht 11, einer optischen Lage 12, einer Trennschicht 13, einer Leiterschicht 14 und einer unteren Schicht 15. In der Leiterschicht 14 sind schematisch Leiterbahnen 16 gezeigt, die bevorzugt als Mikrostrip-Wellenleiter ausgeführt sind. Der Aufbau unterhalb der Trennschicht 13 entspricht dabei der bekannten Technologie von Leiterplatten. Die gezeigte Ausführung dient nur der Illustration. Insbesondere sind meist zusätzliche Masseschichten und eine größere Anzahl von Leiterschichten vorgesehen. Weitere Leiterbahnen sind auch auf der Deckschicht und auf der nach außen gerichteten Oberfläche der unteren Schicht 15 vorgesehen. Ferner nicht gezeigt sind bekannte metallisierte Durchführungslöcher, mit denen Leiterbahnen verschiedener Lagen miteinander verbunden und an die Oberfläche zu Anschlußpunkten geführt werden.

Im folgenden wird zunächst eine Situation beschrieben, bei der bereits optische Leiter 22a, 22c in einer optischen Lage 12 eingebettet sind. Mögliche Herstellungsverfahren hierzu sind bekannt und z.B. in dem Artikel von B.L. Booth, Recent developments in polymer waveguide technology and applications for data link and optical interconnect systems, Proceedings of the SPIE 1996, vol. 2691, p2-8. Ein Herstellungsverfahren im Rahmen dieser Erfindung wird weiter unten beschrieben, bei der an Stelle der in Fig. 1 dargestellten optischen Leiter mit kreisförmigem Querschnitt solche mit rechteckigem Querschnitt entstehen. Die optischen Leiter 22a haben beispielsweise eine Dicke von 100µm und einen vorbestimmten Abstand von 300µm zueinander. Gemäß der Erfindung sind in einem gleichfalls vorbestimmten Abstand Führungselemente 20a, 20b in der optischen Lage vorhanden, die im dargestellten bevorzugten Fall als Hohlzylinder 20a, 20b mit einer Bohrung 21a, 21b ausgeführt sind. Anstelle von Hohlzylindern können selbstverständlich allgemein auch andere prismatische Körper mit einem prismatischen Hohlraum derselben Achse eingesetzt werden.

Zum Anschluß an die optischen Leiter ist in der Leiterplatte eine quaderförmig dargestellte Ausnehmung 23 vorgesehen. Diese wird bevorzugt durch einen Fräsvorgang erzeugt, wobei das Fräswerkzeug in Richtung A quer zur Achse der optischen Leiter arbeitet, so daß die senkrecht zur Achse der zeigende Frontfläche 24 glatt ist. Die Oberfläche der längs der optischen Leiter liegenden Seitenflächen der Ausnehmung 23 ist ohne Bedeutung, solange die Ausnehmung eine ausreichende Größe aufweist.

Fig. 2 zeigt eine Sicht von oben auf die Leiterplatte 10. In der Leiterplatte 10 liegen, und sind daher gestrichelt dargestellt, optische Leiter 22a und Hohlzylinder 20a, 20b mit Innenbohrungen 21a, 21b. Die optischen Leiter erstrecken sich, wie in der Figur angedeutet, zumindest in einer Richtung weiter längs der Oberfläche der Leiterplatte 10. Die Ausnehmung 23 wird erzeugt, indem ein Fräswerkzeug in Richtung des Pfeiles A quer zur Richtung der Fasern einen Schlitz in die Leiterplatte fräst. Dabei werden die optischen Leiter durchtrennt. An der glatten Seitenwandung 24 entstehen dann freiliegende Stirnflächen. Gleichzeitig werden die Hohlzylinder 20a, 20b durchtrennt, so daß an der glatten Stirnfläche die zu den Bohrungen 21a, 21b gehörigen Öffnungen und damit Sacklöcher 25a, 25b entstehen. Die Hohlzylinder sind so lang, daß im Rahmen der Positioniergenauigkeit des Fräswerkzeugs sichergestellt ist, daß ausreichend tiefe Sacklöcher entstehen. Dabei sind die Hohlzylinder entweder an den Enden zu verschließen oder die Viskosität der Einbettungsmasse so hoch zu wählen, daß diese nicht weit in die Enden der Hohlzylinder eindringt. Die durch den Fräsvorgang freigelegten Enden der optischen Leiter 22a sind gegebenenfalls noch zu polieren.

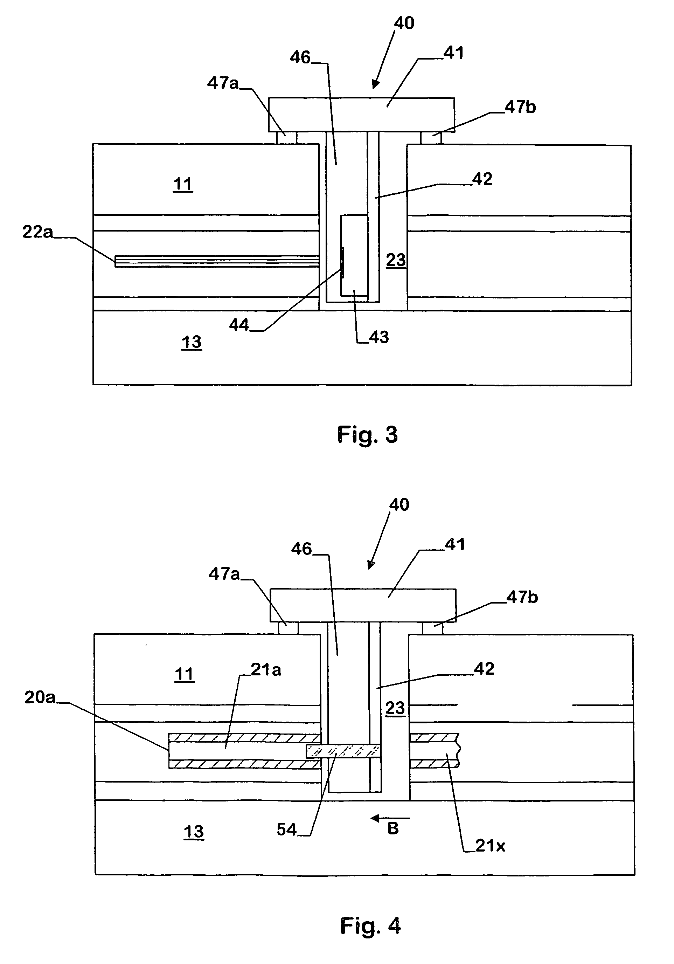

In Fig. 3 ist ein Schnitt senkrecht zur Leiterplatte längs eines optischen Leiters 22a gezeigt. In der Ausnehmung 23 ist ein opto-elektrischer Wandler 40 eingesetzt. Die Darstellung ist auch hier nicht maßstabsgerecht. Die Dicke der Leiterplatte beträgt ca. 2 mm und der Durchmesser der optischen Leiter ca. 100µm. Der opto-elektrische Wandler 40 besteht aus einer Basisplatte 41, welche parallel zu der Oberfläche der Leiterplatte zu liegen kommt, und einem dazu senkrechten Träger 42. Auf dem senkrechten Träger 42 ist ein optischer Transmitter 43 (Sender oder Empfänger) aufgebaut, welcher eine optisch aktive Fläche 44 besitzt. Der optische Transmitter 43 ist bevorzugt eine integrierte Schaltung, die mit nicht gezeigten Anschluß-(Bond-) Drähten angeschlossen ist. Dabei können diese Bond-Drähte entweder an den Träger 42 oder die Basisplatte 41 angeschlossen sein. Zum Schutz der integrierten Schaltung 43 und der Bonddrähte ist eine Schicht 46 aufgebracht, die bevorzugt vollständig transparent ist. Diese Schicht hat einen an die optische Wellenlänge angepaßten Brechungsindex, der beispielsweise die Hälfte des Brechungsindexes des optischen Leiters 22a, an die gekoppelt werden soll, beträgt.

An der der Leiterplatte zugewandten Unterseite der Basisplatte sind Lötanschlüsse 47a, 47b für Oberflächemontage (SMD) vorgesehen, die hier nur symbolisiert dargestellt sind. Dabei sind zudem der Übersichtlichkeit halber die Leiterbahnen, mit denen die Lötanschlüsse 47a, 47b verbunden werden, nicht gezeigt.

In Fig. 4 ist ein Schnitt parallel zu dem in Fig. 3 gezeigten, hier jedoch längs dem Hohlzylinder 20a dargestellt. Der Hohlzylinder 20a wird durch den Schnitt aufgetrennt. Es ist der in der Zeichnung links verbleibende Teil dargestellt. Bei dem Herstellprozeß entsteht in der Regel auf der gegenüberliegenden Seite ein Rest 21x, der dort verbleiben kann. Auf dem Träger 42 ist senkrecht ein Zapfen 54 befestigt, welcher bündig in die Innenbohrung des Hohlzylinders 20a paßt. Der Koppler 40 wird von oben in die Leiterplatte eingesetzt und dann in Richtung des Pfeils B bewegt, so daß der Zapfen 54 in die Innenbohrung 21a des Hohlzylinders 20a eintaucht. Damit ist dann die Lage des Zapfens in den beiden Dimensionen, die nicht der Richtung des Pfeiles B entsprechen, fixiert. Die Anschlußpunkte 47a, 47b können die notwendigen Toleranzen auffangen, da vorzugsweise eine Verbindung durch Löten erfolgt.

Wie in Fig. 1 und Fig. 2 ersichtlich, sind in der gleichen Ebene wie die optischen Leiter, jedoch rechts und links davon angeordnet, zwei Hohlzylinder vorgesehen. Nach dem Einsetzen des Trägers, der dann auch zwei Zapfen hat, ist damit die Lage des Trägers relativ zu den Hohlzylindern fixiert und bestimmt. Bei der Fertigung des Kopplers 40 muß daher sichergestellt sein, daß die optisch aktiven Flächen 44 der Transmitter 43 mit den Zapfen 54 in einer Ebene liegen und die Transmitter 43 von den Zapfen einen gegebenen Abstand haben. Da es sich um ein relativ kleines Bauteil in der Größe eines bekannten MT-Steckers handelt, kann die Technik aus der Fertigung von MT-Steckern übernommen werden. Ferner muß bei der Fertigung der Leiterplatte dafür gesorgt werden, daß die Lichtleiter 22a den vorgegebenen Abstand untereinander und zu den Hohlzylindern 20a, 20b haben.

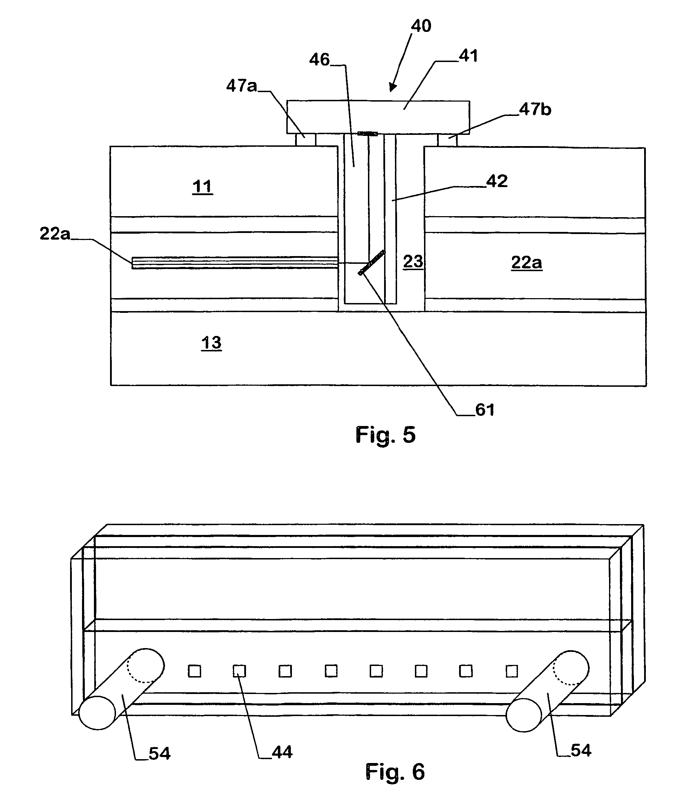

In Fig. 5 ist eine alternative Anordnung dargestellt, bei der ein Spiegel 61 die aus dem Lichtleiter 22a austretenden Lichtstrahlen nach oben umlenkt und auf ein optisches Element auf der Basisplatte 41 wirft. Da hierzu keine Verbindungen auf der Trägerplatte 42 notwendig sind, ist diese Form in dieser Beziehung vorteilhaft. Nachteilig ist jedoch, daß der Spiegel genau ausgerichtet sein muß und das Licht zwischen Spiegel und optischem Element nicht mehr geführt wird.

In Fig. 6 ist eine perspektivische Sicht auf einen Koppler gezeigt, bei der die Führungsstifte 54 und die optischen Elemente 44 hervorgehoben sind.

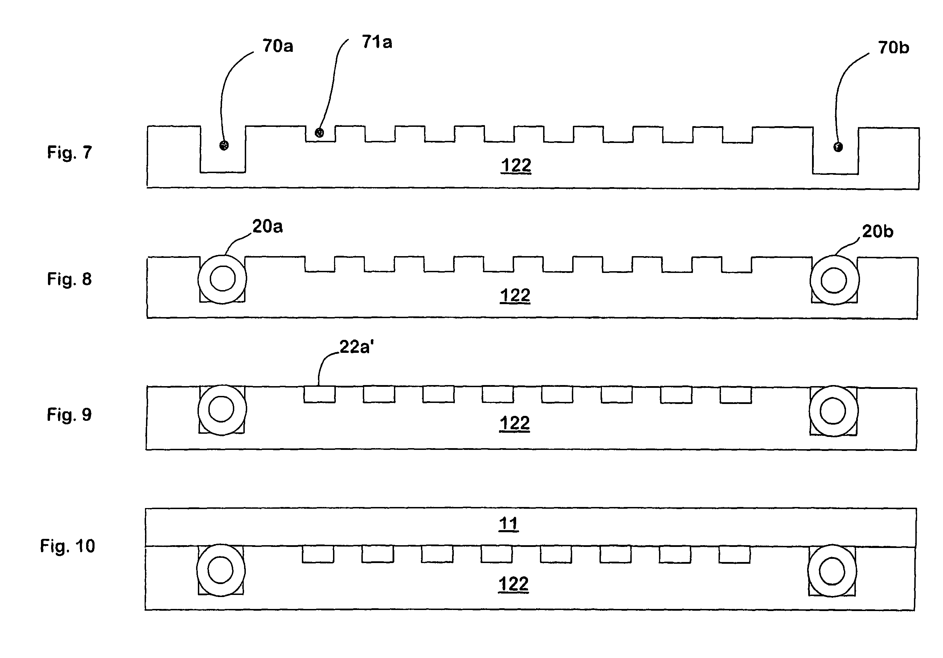

Für eine Herstellung der optischen Lagen kann zweckmäßig ein Fertigungsverfahren eingesetzt werden, das in den Fig. 7 bis 10 dargestellt ist. Gezeigt ist nur die Ebene, in der die optischen Leiter vorhanden sind. Die anderen Lagen, insbesondere die mit elektrischen Leitern, sind der Übersichtlichkeit halber weggelassen.

Zunächst wird, wie in Fig. 7 dargestellt, eine optische Basisschicht 122 mit dem Brechungsindex n₁ hergestellt, z.B. durch Gießen auf ein darunter liegende, z.B. in Fig.1 dargestellte, Trennschicht 13. In diese Basisschicht 122 werden Rillen 71a für die optischen Leiter angelegt, entweder durch Fräsen, durch Prägestempel, durch Ätzen oder andere Verfahren. Hierbei ist die relative Genauigkeit des Rillenabstands zueinander von entscheidender Bedeutung, nicht jedoch die absolute Ausrichtung auf der Leiterplatte. Zugleich werden Rillenabschnitte 70a, 70b an den Stellen erstellt, an denen Verbinder benötigt werden. In die Rillenabschnitte 70a, 70b werden, wie in Fig. 8 gezeigt, Hohlzylinder 20a, 20b eingelegt bzw. eingepreßt. Ferner wird, wie in Fig. 9 angedeutet, die Rillen 71a mit einer optisch transparenten Masse 22a' ausgefüllt, die als Lichtleiter geeignet ist und einen Brechungindex n₂ > n₁ hat. Dies kann z.B. durch Aufspachteln oder Siebdruck mit nachfolgendem Glätten der Oberfläche vor oder nach der Aushärtung der optische transparenten Masse 22a' erfolgen. Bevorzugt werden die Hohlzylinder zuvor eingelegt, damit die Rillenabschnitte 70a, 70b nicht durch die optisch transparente Masse verunreinigt werden; bei entsprechender Ausgestaltung des Auftragsverfahrens kann die Reihenfolge umgekehrt werden.

Alternativ (nicht dargestellt) können auch bereits fertig vorliegene Abschnitte einer Lichtleitfaser in die Rillen eingedrückt werden. Die Rillen dienen dann der Fixierung des Abstands voneinander und den Hohlzylindern.

In einem weiteren Schritt nach Fig. 10 wird darüber eine optische Deckschicht 10 mit einem Brechungsindex n₃ < n₂ aufgetragen. Auf diese können dann in bekannter Art elektische Leiterbahnen, auch in mehreren Lagen, durch additive oder subtraktive Verfahren aufgetragen werden. Die optische Lage ist dabei vollkommen geschützt, da sowohl die Rillen 71a als auch die Rillenabschnitte 70a, 70b nicht an den Rand der Leiterplatte geführt werden. Wenn die elektischen Leiterbahnen einschließlich eventueller Durchkontaktierungen fertig galvanisiert und bearbeitet sind, kann der oben beschriebene Verfahrensschritt einsetzen, nach dem gemäß Fig. 2 ein Schlitz in die Leiterplatte 10 in Richtung A gefräst wird, der die optischen Leiter 22a wie auch die Hohlzylinder 20a, 20b freilegt. Dieser Schlitz kann selbstverständlich auch durch die gesamte Leiterplatte reichen, so daß ein Loch entsteht.

## Patentansprüche

1. Anordnung zur Fixierung einer Position bei einer Leiterplatte mit
- mindestens einem sich im Innern der Leiterplatte (10) parallel zu deren Oberfläche befindenden Hohlkörper (20a, 20b), dessen Innenwandung die zu fixierende Position bestimmt,
- einer in der Leiterplatte (10) vorhandenen Ausnehmung (23), die an einen Teil des Hohlkörpers (20a, 20b) grenzt und damit einen Zugang in axialer Richtung zur Innenwandung darstellt,
- einem Koppler (40), der mindestens einen bündig in den Hohlkörper (20a, 20b) passenden Führungsstift (54) aufweist,
**dadurch gekennzeichnet,**
**daß** der Koppler (40) einen auf der Leiterplatte (10) aufzuliegenden Basisteil (41) und einen senkrecht dazu angebrachten Träger (42) aufweist, auf dem der Führungsstift (54) senkrecht stehend befestigt ist, und daß der Koppler (40) in die Ausnehmung (23) einsetzbar und dort derart bewegbar ist,
**daß** der Führungsstift (54) in den Hohlkörper (20a, 20b) eintaucht.

2. Anordnung nach Anspruch 1,
bei der die Hohlkörper (20a, 20b) prismatisch geformt sind, und bei der mindestens ein optischer Leiter (16) in der Leiterplatte (10) vorhanden ist, der nahe den prismatischen Hohlkörpern (20a, 20b) achsenparallel verläuft.

3. Anordnung nach Anspruch 1,
bei der der Hohlkörper (20a, 20b) ein in MT-Steckverbindern verwendbarer Hohlzylinder ist.

4. Anordnung nach einem der Ansprüche 1 bis 3,
bei der ein elektro-optischer Wandler (43) auf dem Träger (42) befestigt ist.

5. Anordnung nach einem der Ansprüche 1 bis 3,
bei der ein optischer Wandler (43) auf dem Basisteil (41) befestigt und über eine Strahlumlenkung auf dem Träger (42) angekoppelt ist.

6. Anordnung nach einem der Ansprüche 1 bis 5,
bei der der Basisteil (41) auf der der Leiterplatte (10) zugewandten Seite elektrische Anschlußfelder (47a, 47b) aufweist.

## Claims

1. Arrangement for fixing a position in a printed circuit board with
- at least one hollow body (20a, 20b), which is situated inside the printed circuit board (10) parallel to the surface thereof and the inner wall of which determines the position to be fixed,
- a cutout (23) present in the printed circuit board (10), said cutout adjoining a part of the hollow body (20a, 20b), and thus representing an access in an axial direction to the inner wall,
- a coupler (40), which has at least one guide pin (54) that fits flush into the hollow body (20a, 20b),
**characterized in that** the coupler (40) has a base part (41) which is to bear on the printed circuit board (10) and a carrier (42), which is attached perpendicularly to said base part and on which the guide pin (54) is fixed in a manner situated perpendicularly, and **in that** the coupler (40) can be inserted into the cutout (23) and can be moved there in such a way that the guide pin (54) dips into the hollow body (20a, 20b).

2. Arrangement according to Claim 1,
wherein the hollow bodies (20a, 20b) are prismatically shaped, and wherein at least one optical conductor (16) is present in the printed circuit board (10), said at least one optical conductor running axially parallel near the prismatic hollow bodies (20a, 20b).

3. Arrangement according to Claim 1,
wherein the hollow body (20a, 20b) is a hollow cylinder which can be used in MT plug connectors.

4. Arrangement according to any of Claims 1 to 3,
wherein an electro-optical transducer (43) is fixed on the carrier (42).

5. Arrangement according to any of Claims 1 to 3.
wherein an optical transducer (43) is fixed on the base part (41) and coupled via a beam deflection on the carrier (42).

6. Arrangement according to any of Claims 1 to 5,
wherein the base part (41) has electrical connection zones (47a, 47b) on the side facing the printed circuit board (10).

## Revendications

1. Agencement, pour la fixation d'une position dans une plaquette à circuits imprimés, comprenant
- au moins un corps ( 20a, 20b ) creux, qui se trouve à l'intérieur de la plaquette ( 10 ) à circuits imprimés, parallèlement à sa surface et dont la paroi intérieure détermine la position à fixer,
- un évidement ( 23 ) qui est présent dans la plaquette à circuits imprimés, qui est voisin d'une partie du corps ( 20a, 20b ) creux et qui représente ainsi un accès dans la direction axiale à la paroi intérieure,
- un coupleur ( 40 ), qui a une tige ( 54 ) de guidage, s'adaptant à affleurement dans le corps ( 20a, 20b ) creux, **caractérisé**
**en ce que** le coupleur ( 40 ) a une partie ( 41 ) de base, mise sur la plaquette ( 10 ) à circuits imprimés, et un support ( 42 ) qui lui est perpendiculaire et sur lequel la tige ( 54 ) de guidage est fixée en lui étant perpendiculaire et en ce que le coupleur ( 40 ) peut être inséré dans l'évidement ( 23 ) et y être déplacé, de manière à ce que la tige ( 54 ) de guidage pénètre dans le corps ( 20a, 20b ) creux.

2. Agencement suivant la revendication 1, dans lequel les corps ( 20a, 20b ) creux sont de forme prismatique et dans lequel au moins un conducteur ( 16 ) optique est présent dans la plaquette ( 10 ) à circuits imprimés, en s'étendant parallèlement à l'axe, à proximité des corps ( 20a, 20b ) creux prismatiques.

3. Agencement suivant la revendication 1,
dans lequel le corps ( 20a, 20b ) creux est un cylindre creux, qui peut être utilisé dans des connecteurs en enfichage MT.

4. Agencement suivant l'une des revendications 1 à 3,
dans lequel un transducteur ( 43 ) électro-optique est fixé sur le support ( 42 ).

5. Agencement suivant l'une des revendications 1 à 3,
dans lequel un convertisseur ( 43 ) optique est fixé sur la partie ( 41 ) de base et est couplé au support ( 42 ) par une déviation du rayonnement.

6. Agencement suivant l'une des revendications 1 à 5,
dans lequel la partie ( 41 ) de base a des parties ( 47a, 47b ) de connexion électrique du côté tourné vers la plaquette ( 10 ) à circuits imprimés.
